Europäisches Patentamt

European Patent Office

Office européen des brevets

(19)

(11) Publication number: **0 209 209 B1**

# EUROPEAN PATENT SPECIFICATION

(12)

(45) Date of publication of patent specification: **02.09.92**

(51) Int. Cl.5: **C30B 7/00**, C30B 29/10

(21) Application number: **86301937.8**

(22) Date of filing: **17.03.86**

(54) Process for manufacturing calcium carbonate single crystals.

(30) Priority: **18.03.85 JP 53892/85**

(43) Date of publication of application:
**21.01.87 Bulletin  87/04**

(45) Publication of the grant of the patent:
**02.09.92 Bulletin  92/36**

(84) Designated Contracting States:
**DE FR GB**

(56) References cited:
**GB-A- 1 468 052**

**JOURNAL OF CRYSTAL GROWTH, vol. 38, 1977, pages 29-37, North-Holland Publishing Co., Amsterdam, NL; F. LEFAUCHEUX et al.: "Defects revealing growth processes"**

**CHEMICAL ABSTRACTS, vol. 56, no. 5, 5th March 1962, column no. 5463i-5464i, Columbus, Ohio, US; N.YU. IKORNIKOVA: "Crysallization of carbonates from solutions of chlorides", & ROST. KRISTALLOV, AKAD. NAUK S.S.S.R., INST. KRIST. 3, 421-7(1961)**

**CHEMICAL ABSTRACTS, vol. 62, no. 1, 4th January 1965, page 79, column no. 79e, N.YU. IKORNIKOVA et al.: "Growing of single cry-**
stals of calcite under hydrothermal conditions", & ROST KRISTALLOV, AKAD. NAUK S.S.S.R, INST. KRISTALLOGR. 4, 92-4(1964)

(73) Proprietor: **SEIKO INSTRUMENTS INC.**
**31-1, Kameido 6-chome Koto-ku**
**Tokyo 136(JP)**

Proprietor: **SHINICHI HIRANO**
**123, Meidai Yada-cho Shukusha 66, Yada-cho 2-chome Higashi-ku**
**Nagoya-shi Aichi(JP)**

(72) Inventor: **Hirano, Shinichi**
**123, Meidai Yada-cho Shukusha 66, Yada-cho 2-chome**
**Higashi-ku Nagoya-shi Aichi(JP)**

(74) Representative: **Miller, Joseph et al**
**J. MILLER & CO. 34 Bedford Row, Holborn**
**London WC1R 4JH(GB)**

Rank Xerox (UK) Business Services

## Description

This invention relates to processes for manufacturing calcium carbonate single crystals widely used in optical polarisers, etc.

Single crystals of calcium carbonate ($CaCO_3$) have optical uses and for this purpose natural calcite crystals are currently used. Calcite crystals exhibit double refraction of incident light. Calcite has a high refractive index and so it is used as a polarising prism in optical apparatus. Because of recent advances in the design of apparatus such as laser optics and optical communication apparatus, etc. there is an increased market for a material with excellent optical characteristics. In this regard, calcite is an ideal material, and is expected to be more and more in demand.

Calcite is obtainable only from natural sources because it is not yet being industrially synthesised. To be of commercial use, natural calcite must be colourless, transparent, have no bubbles or cracks, no twining, no internal strains and be greater than a certain size. However, calcite that will meet this requirement is found only in limited quantities in the Republic of South Africa, Mexico, etc., and reserves are running low.

There have been experiments to synthesise calcium carbonate single crystals. One way is by crystallisation from a solvent, another is synthesising from a gel, a third is crystallisation from a flux or melt, a fourth is hydrothermal synthesis, and recently a FZ method under high pressure has been suggested. However, optical characteristics such as transparency of resulting crystals have not been entirely satisfactory due to defects such as impurities, mixing, dislocations, inclusions, or internal strains.

Among the methods tried for the manufacture of calcium carbonate single crystals, hydrothermal synthesis is closest to the conditions under which natural calcite was grown in a hydrothermal ore deposit. Therefore, hydrothermal synthesis enables calcium carbonate single crystals with characteristics similar to natural calcite to be achieved.

The hydrothermal synthesis process used to date for the manufacture of calcium carbonate single crystals utilises an aqueous solvent at fixed temperature and pressure in an autoclave. Alkaline aqueous solutions such as sodium hydroxide (NaOH) or alkali carbonate aqueous solutions such as sodium carbonate ($Na_2CO_3$), potassium carbonate ($K_2CO_3$), etc. are generally used as the aqueous solvent. Growth of calcium carbonate single crystals in this way is essentially an extension of conventional growth technology for artificial crystals. Under the following conditions:

Solvent - 6 mol $K_2CO_3$ aqueous solution

Temperature - 410°C to 445°C

Pressure - 1720 (kg/cm$^2$) (1720 atmospheres)

Growth speed - 50 microns per day

about 3mm growth layer of a calcium carbonate single crystal has been obtained.

Hydrothermal synthesis is disclosed in D.R. Kinlock H, R.F. Belt, R.C. Puttbac H, Journal of Crystal Growth 24/25 (1974) 610-613.

Calcium carbonate crystals can be grown from an alkali carbonate aqueous solution by a hydrothermal process as described above, but there are problems. Firstly, due to the high concentration of solvent inclusions frequently occur in the resulting crystals. These inclusions will result in inferior optical characteristics. Next, due to a high concentration of solvent it is impossible to achieve sufficient pressure for quantity production. In other words, the higher the solvent concentration, the lower the obtained pressure becomes even with the same filling-up rate. In the case of a 6 mol concentration of $K_2CO_3$ aqueous solution at 445°C and a filling-up rate of nearly 100%, it is impossible to obtain a pressure of 1720 kg/cm$^2$ (1720 atmospheres). Due to this, it is necessary to apply additional pressure from outside the autoclave, causing the apparatus and pressure systems etc. to be too complicated. Using an alkali carbonate aqueous solution, the growth speed will be very slow, i.e. 50 microns per day, and therefore it will take more or less a year to grow crystals large enough to be used as optical elements.

The growth of calcite crystals in a chloride solution is discussed in Chemical Abstracts, vol. 62, No. 1, 4th January 1965, page 79, N. Yu Ikornikova et al: "Growing of single chrystals of calcite under hydrothermal conditions". However, according to this document, experiments for growing crystals under conditions of temperature of 400° to 450° and high pressures were unsuccessful in that H developed in the system, $CaCO_3$ -NaCl-$H_2O$-Fe, and then reacted with $CO_2$, which interfered with the growth.

The present invention seeks to provide a simple method to grow relatively quickly excellent calcium carbonate single crystals with good optical characteristics.

According to the present invention there is provided a process for manufacturing a calcium carbonate single crystal by hydro-thermal synthesis at a given temperature and pressure, characterised in that an alkali chloride aqueous solution is used as a solvent, and in that the hydro-thermal synthesis is carried out a solvent temperature in the range from 470°C to 520°C and at a pressure in the range from around 750 $kg/cm^2$ to less than 1000 $kg/cm^2$.

The invention is illustrated, merely by way of example, in the accompanying drawings, in which:-

Figure 1 is a sectional view of a test tube used in Example 1 according to the present invention; and

Figure 2 is a sectional view of a test tube used in Example 2 according to the present invention.

The problems encountered in growing calcium carbonate single crystals by prior hydro-thermal synthesis, namely inferior optical quality, complicated apparatus, and lengthy growth period, etc., result from having to use a high concentration solvent and high pressure. In other words, the problems stem from the choice of solvent and growth conditions.

A chloride aqueous solution has now been found best to avoid these problems, among various kinds of existing solvent such as alkaline, carbonate and acid solutions.

In the present invention, hydro-thermal synthesis initiating material is dissolved in a suitable aqueous solution of solvent at appropriate temperature and pressure, and crystallization on a substrate occurs on gradual cooling or by transporting nourishment (material) through a temperature differential. The solvent should, therefore, be such that the initiating material dissolves well in it and it should have little corrosive action on apparatus used. A chloride aqueous solution as a solvent has been found to be ideal.

The invention is further described with reference to the following Examples.

EXAMPLE 1

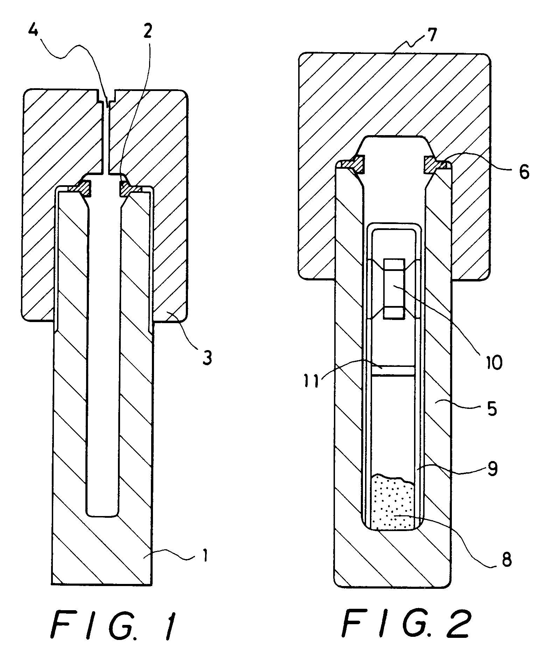

As initiating material, commercially available calcium carbonate of high purity is used. For hydrothermal synthesis an autoclaval test tube of stellite quality No. 25 was used. Figure 1 shows the structure of the test tube having a pressure vessel body 1 with a cover 3 and a seal 2.

The inside temperature of the pressure vessel body is taken to a temperature measuring hole 4. A gold capsule, 3mm-5mm in diameter was placed in the test tube. The initiating material and solvent were poured into the test tube for hydrothermal synthesis. In this case, the pressure between the inside and the outside of the capsule was balanced by filling the inside of the pressure vessel with distilled water.

The result using various solvents is shown in the following table:

| Solvent | Conditions of Hydrothermal Synthesis |
|---|---|
| 3 Mol NaCl | Temp. – 470°C <br> Pressure – 750 $kg/cm^2$ <br> Growth Period – 7 days |
| 3 Mol NaCl | Temp. – 520°C <br> Pressure – 750 $kg/cm^2$ <br> Growth Period – 7 days |
| 3 Mol KCl | Temp. – 490°C <br> Pressure – 750 $kg/cm^2$ <br> Growth Period – 7 days |
| 3 Mol LiCl | Temp. – 490°C <br> Pressure – 750 $kg/cm^2$ <br> Growth Period – 7 days |
| 3 Mol LiCl | Temp. 520°C <br> Pressure – 750 $kg/cm^2$ <br> Growth Period – 7 days |
| 3 Mol NaCl | Temp. – 500°C <br> Pressure – 500 $kg/cm^2$ <br> Growth Period – 7 days. |

In every case it was found that crystals were grown using any one of sodium chloride (NaCl), potassium chloride (KCl), and lithium chloride (LiCl) as the solvent. By making the concentration of the alkali chloride in the aqueous solution relatively large, good crystal growth was achieved. However, it was found that a molar concentration of about 3 Mol was preferred bearing in mind the pressure and because it was easier to handle. As for pressure, unlike the case of using an alkali carbonate aqueous solution, it was possible to grow crystals using pressures less than 1000 kg/cm$^2$, and a very good crystal growth at pressures of around 750 kg/cm$^2$ were achieved. However, at a pressure of 500 kg/cm$^2$, crystalline growth was found to be very slow. As for temperature, good crystal growth was achieved at 470°C. If the temperature was over 520°C, it was still possible to grow crystals, however, but there was the possibility of reduced quality.

The best calcium carbonate single crystals were grown at a pressure of 750 kg/cm$^2$ from sodium chloride (NaCl) aqueous solution. The result at different temperatures was as follows:

| Solution | Temp. | Pressure | Size of Crystal Grown |
|---|---|---|---|
| NaCl | 470°C | 750 kg/cm$^2$ | 0.4 mm – 0.5 mm |
| NaCl | 520°C | 750 kg/cm$^2$ | 0.6 mm – 1.0 mm |

The higher the growth temperature, the quicker the growth. In the case of using a solvent of potassium chloride (KCl) the speed of growth was found too slow to be of practical use.

A solvent of lithium chloride (LiCl) solution achieved about the same effect as the sodium chloride solvent and it was possible to obtain a crystal size over 1.0 mm at 520°C.

It was confirmed by X-ray diffraction that in each case the crystals grown were calcium carbonate single crystals.

EXAMPLE 2

Figure 2 is a sectional view illustrating a typical test tube used in this Example. The test tube was made of stellite 25 as in Example 1, however the inside was lined with platinum in order to avoid contamination by pollutants. A pressure vessel body 5 was sealed with a cover 7 through a sealing ring 6. At the bottom of the pressure vessel body 5 initiating material 8 for the crystals to be grown is placed. The initiating material was as in Example 1 being refined and recrystallised in sodium nitrate (NaNO$_3$) and was powdered. A crystal support frame 9 carries a species or seed crystal 10 over the initiating material 8. The seed crystal 10 was a calcite (1011) crystal of natural optical grade. It is necessary to choose a seed crystal with few internal inclusions, and little lattice displacement, etc. so that defects in the single crystal to be grown thereon may be avoided. A baffle 11 is provided between the initiating material 8 and the seed crystal 10 and is supported on the frame 9. The inside of the pressure vessel body 5 was filled up with 3 mol sodium chloride (NaCl) aqueous solution as solvent at such a filling-up rate as to enable a predetermined temperatue and pressure to be achieved.

Hydrothermal synthesis was conducted under the same conditions as in Example 1, namely,

Temperature of seed crystal 10 - 470°C

Temperature of initiating material 8 - 520°C

Solvent - 3 Mol NaCl aqueous solution

Pressure - 750 kg/cm$_2$

Growth period - 50 days.

As a result a calcium carbonate single crystal was grown on the seed crystal 10 as follows:-

Thickness of grown layer - 6 mm

Growth speed: 120 microns per day.

Character of grown layer: calcium carbonate single crystal (determined by X-ray diffraction). Its optical characteristics was the same as those of natural calcite (from measurment of permeability rate, compound refractive index, etc.).

From the above discussion it will be appreciated that it is easier for growth of calcium carbonate single crystals to be industrialised by hydrothermal synthesis because a pressure less than 1000 kg/cm$^2$ is used and, at the same time, reducing defects inside the crystals grown, compared with the prior growth methods of calcium carbonate single crystals by using alkali carbonate aqueous solutions. In addition, the growth speed of the crystals is over twice that achieved with prior methods and this is a very favourable characteristic in the case of industrialisation. It is thus possible for calcium carbonate single crystals of optical grade quality equal to that of natural calcite to be made industrially by the same technology as that for the current artificial crystals. To be industrially able to produce such crystals equal in quality to natural optical grade calcite will mean that it will be possible always to provide a market for such crystals with the same quality. Because of the dependence upon natural calcite, there has been no guarantee of either a regular supply or consistent quality. Industrialisation of calcium carbonate single crystals will achieve such consistency and enhance their use in optical elements and parts etc. used in a whole range of apparatus and will enable their characteristics to be improved.

## Claims

1. A process for manufacturing a calcium carbonate single crystal by hydro-thermal synthesis at a given temperature and pressure, characterised in that an alkali chloride aqueous solution is used as a solvent, and in that the hydro-thermal synthesis is carried out a solvent temperature in the range from 470°C to 520°C and at a pressure in the range from around 750 kg/cm$^2$ to less than 1000 kg/cm$^2$.

2. A process as claimed in claim 1, characterised in that the solvent is any one of a sodium chloride, potassium chloride and lithium chloride aqueous solution.

## Patentansprüche

1. Verfahren zur Herstellung eines Calciumcarbonat-Einkristalls durch hydrothermale Synthese bei einer gegebenen Temperatur und einem gegebenen Druck, **dadurch gekennzeichnet,** daß eine wäßrige Alkalichlorid-Lösung als Lösungsmittel verwendet wird und daß die hydrothermale Synthese bei einer Lösungsmitteltemperatur im Bereich von 470°C bis 520°C und bei einem Druck im Bereich von etwa 750 kg/cm$^2$ bis weniger als 1000 kg/cm$^2$ durchgeführt wird.

2. Verfahren nach Anspruch 1, **dadurch gekennzeichnet,** daß das Lösungsmittel aus einer wäßrigen Natriumchlorid-, Kaliumchloridund Lithiumchlorid-Lösung ausgewählt ist.

## Revendications

1. Procédé de préparation d'un monocristal de carbonate de calcium par synthèse hydrothermique à une température et sous une pression données, caractérisé en ce qu'il consiste à utiliser, comme solvant, une solution aqueuse de chlorure de métal alcalin, et à effectuer la synthèse hydrothermique à une température du solvant comprise entre 470°C et 520°C et sous une pression allant d'environ 750 kg/cm$^2$ à moins de 1000 kg/cm$^2$.

2. Procédé suivant la revendication 1, caractérisé en ce que le solvant est une solution aqueuse de chlorure de sodium, de chlorure de potassium ou de chlorure de lithium.

FIG. 1

FIG. 2